Europäisches Patentamt

European Patent Office

Office européen des brevets

(11) Numéro de publication: **0 145 557**
**B1**

# (12) FASCICULE DE BREVET EUROPEEN

(45) Date de publication du fascicule du brevet:
26.07.89

(51) Int. Cl.⁴: **H 05 K 3/34,** B 23 K 1/08,
B 23 K 1/20

(21) Numéro de dépôt: **84402304.4**

(22) Date de dépôt: **13.11.84**

(54) Procédé de brasage à la vague et capteur capillaire de brasure mettant en oeuvre ce procédé.

(30) Priorité: **15.11.83 FR 8318128**

(43) Date de publication de la demande:
**19.06.85 Bulletin 85/25**

(45) Mention de la délivrance du brevet:
**26.07.89 Bulletin 89/30**

(84) Etats contractants désignés:
**DE GB IT NL**

(56) Documents cités:
**DE-A- 3 231 056**
**FR-A- 1 369 630**
**FR-A- 2 487 153**
**GB-A- 811 509**

**IBM TECHNICAL DISCLOSURE BULLETIN, vol. 21, no. 9,
février 1979, page 3591, New York, US; C.S.K. Ng:
"Circuit module package"
SOLID STATE TECHNOLOGY, vol. 26, no. 3, mars 1983,
pages 103-107, Port Washington, New York, US; P.M.
HALL: "Solder attachment of leadless ceramic chip
carriers"**

(73) Titulaire: **THOMSON-CSF, 51, Esplanade du Général de
Gaulle, F-92800 Puteaux (FR)**

(72) Inventeur: **Lacruche, Bernard, THOMSON-CSF
SCPI 173, bld Haussmann, F-75379 Paris Cedex 08 (FR)**
Inventeur: **Bonhoure, Francis, THOMSON-CSF
SCPI 173, bld Haussmann, F-75379 Paris Cedex 08 (FR)**

(74) Mandataire: **Lepercque, Jean et al, THOMSON-CSF
SCPI, F-92045 PARIS LA DEFENSE CEDEX 67 (FR)**

ACTORUM AG

## Description

L'invention concerne un procédé de brasage à la vague permettant de braser, sur une carte de circuits imprimés, des composants dont les broches de connexion ne traversent pas la carte. L'invention concerne également des capteurs capillaires mettant en œuvre ce procédé.

Selon une technique courante, la connexion d'un composant sur une carte de circuits imprimés se fait à l'aide de broches appartenant au composant, traversant la carte de circuits imprimés par des trous de connexion, et par brasage des broches à des pastilles de connexion situés sur la face opposée de la carte. L'opération de brasage se fait par passage de la carte au dessus d'une vague de brasure en fusion, la face de la carte portant les pastilles de connexion entrant au contact, lors de ce passage, avec la vague de brasure.

Selon une technique récente de connexion, cf. par exemple FR-A-2 487 153, les broches des composants ne traversent pas la carte de circuits imprimés. Les composants possèdent des plots de connexion qui sont mis simplement en contact avec des plots de connexions de la carte de circuits imprimés et auxquels ils sont ensuite brasés. Ce brasage peut être effectué également par passage sur une vague de brasure. Pour celà, les composants sont au préalable mis en position sur la carte et immobilisés par collage, les plots de connexion des composants étant en contact avec les plots de connexion de la carte. La carte est ensuite passée au dessus de la vague de brasure, la face portant les plots de connexion ainsi que les composants entrant en contact avec la vague de brasure. Lors de ce passage, chaque composant baigne donc dans le bain de brasure en fusion. La face du composant qui attaque la vague de brasure est, en principe, en contact en entier avec la brasure. Les parties métallisées de cette face sont mouillées par la brasure et le brasage des plots de connexion de cette face du composant avec les plots de la carte peut se faire. Par contre, en raison de la température du bain de brasure, la carte doit passer à une vitesse suffisante, pour éviter l'échauffement des composants. De ce fait, l'écoulement du fluide de brasure sur les côtés et sur la face arrière de chaque composant est et que certaines parties du composant peuvent ne pas être en contact avec la brasure. Le brasage des plots de connexion peut ne pas être assuré.

L'invention se fixe pour but un dispositif et un procédé permettant d'assurer un brasage de tous les plots de connexion d'un composant sur les plots de connexion d'un substrat.

L'invention concerne donc un dispositif pour brasage de composant en surface, ledit composant possédant sur une première face au moins un plot de connexion pour connexion à au moins un plage de connexion d'une face d'un substrat, le ou les plots de connexion du composant et la ou les plages de connexion du substrat étant situés d'un même côté du substrat par rapport à ladite face du substrat, le composant comportant une deuxième face opposée à la première face, caractérisé en ce qu'il comporte au moins un élément métallisé reliant chaque plot de connexion à la deuxième face et affleurant la deuxième face du composant.

L'invention concerne également un procédé de brasage utilisant des tels dispositifs pour brasage.

L'invention sera mieux comprise et d'autres caractéristiques apparaîtront à l'aide de la description qui va suivre et des figures annexées parmi lesquelles:

— les figures 1 à 3 sont des schémas explicatifs d'un système de brasage à la vague de l'art connu auxquels s'applique l'invention;

— les figures 4 et 5 représentent des schémas explicatifs du procédé selon l'invention;

— les figures 6 et 7 représentent des exemples de capteurs capillaires de brasure selon l'invention;

— les figures 8 et 9 représentent une exemple de réalisation d'un autre capteur capillaire selon l'invention;

— la figure 10 représente un capteur capillaire de brasure selon l'invention pour circuits à plusieurs couches;

— la figure 11 représente une variante d'un capteur capillaire de brasure.

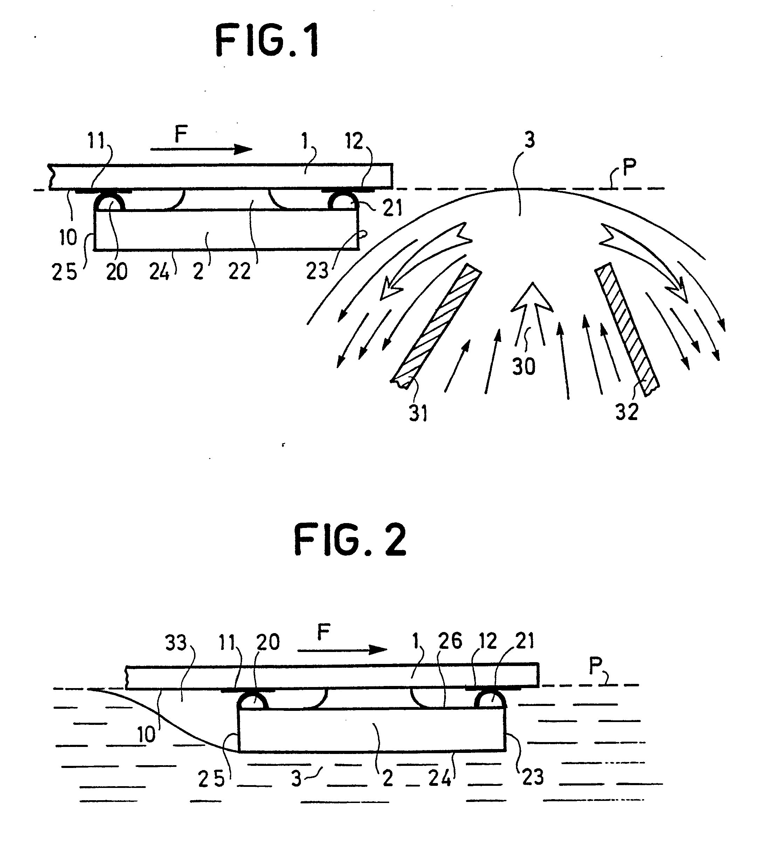

En se reportant aux figures 1 à 3, on va décrire un système de brasage à la vague. Sur la figure 1, on trouve une carte de circuits imprimés 1 éuipée d'un composant 2. Une vague d'alliage de brasage en fusion 3 est produite par un flux d'alliage 30 canalisé par deux pièces 31 et 32. Cette vague effleure un plan P. La carte 1 est disposée sur un dispositif de transfert non représenté et connu de la technique. Elle est déplacée selon le sens indiqué par la flèche F avec sa face 10 à souder située dans le plan P.

La carte 1 possède sur sa face 10 des circuits imprimés non représentés et des plots de connexion 11 et 12. Le composant 2 est collé à la face 10 de la carte 1 par un bossage 22. Le composant 2 possède en outre, sur sa face 26, des plots de connexion tel que 20 et 21 qui sont mis en contact (ou au voisinage) des plots de connexion 11 et 12 de la carte 1.

Lorsque la carte 1 passe sur la vague de brasure 3, celle-ci balaye la surface de la carte. La brasure mouille les parties métalliques avec lesquelles elle entre en contact et les pièces métalliques, tels que plots de connexion, sont brasées. Cependant, comme on le voit sur la figure, le composant baigne dans la brasure en fusion durant le déplacement de la carte. On a donc intérêt à ce que ce déplacement soit suffisamment rapide. Il se trouve alors, en raison de l'écoulement du fluide de brasure autour du composant 2, que des parties du composant ne sont pas mis en contact avec la brasure. Sur la figure 2, on peut voir que la face avant 23 du composant ainsi que les plots de connexion 12 et 21 sont baignés dans la brasure, il en est de même de la face 24 du composant. Par contre, à la suite de la face arrière 25 par rapport au mouvement selon la flèche F se créé une zone 33 sans brasure. Les plots de connexion 11 et 20 ne peuvent donc pas être brasés.

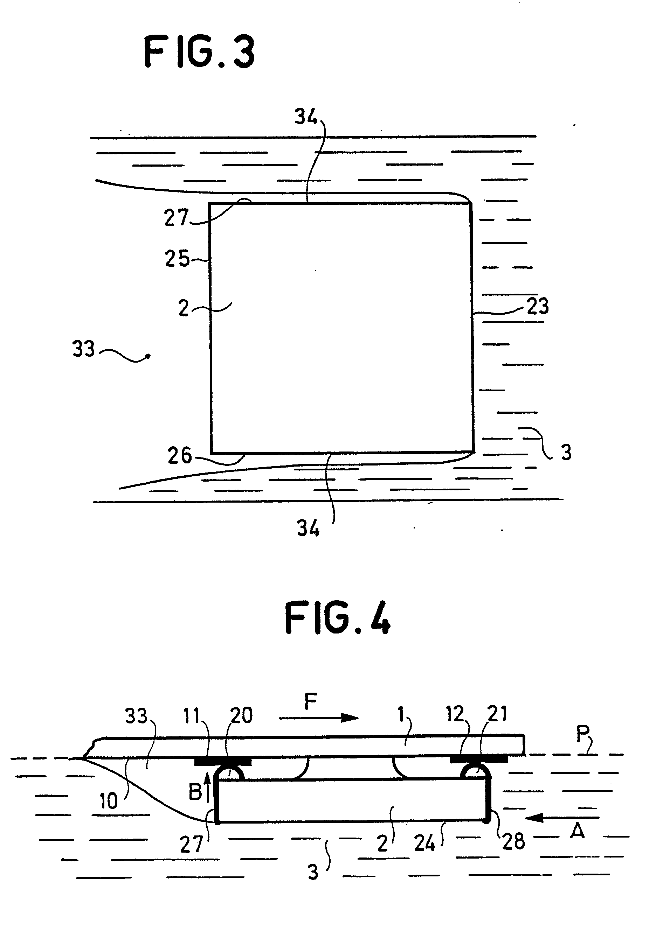

De même comme on peut le voir sur la figure 3, il peut se produire une absence de brasure dans la zone 34 de part et d'autre des faces latérales 27 et 37 du composant.

C'est pourquoi l'invention, avant l'étape de passage de la carte 2 sur la vague de brasure, prévoit de placer des capteurs capillaires de brasures reliant chaque plot, tel que 20, à la face 24 du composant. Ainsi lors du passage de la carte 2 sur la vague 3, la brasure en balayant la face 24 du composant entre en contact avec le capteur capillaire, le mouille, et progresse par capillarité vers les plots de connexion.

Sur la figure 4 on a représenté un capteur capillaire 27 reliant le plot de connexion 20 à la face 24 du composant. Pour des questions d'uniformité de fabrication un capteur 28, bien qu'il ne soit indispensable, relie le plot de connexion 21 à la face 24. La carte 1, se déplaçant selon la flèche F, en mouvement relatif, la brasure se déplace par rapport au composant selon la flèche A. Lorsque la brasure touche le capteur capillaire 27, elle mouille celle-ci et tend à se répandre sur toute sa surface. En particulier, elle progresse selon la flèche B vers des plots de connexion 20 et 11 qu'elle brase ensemble.

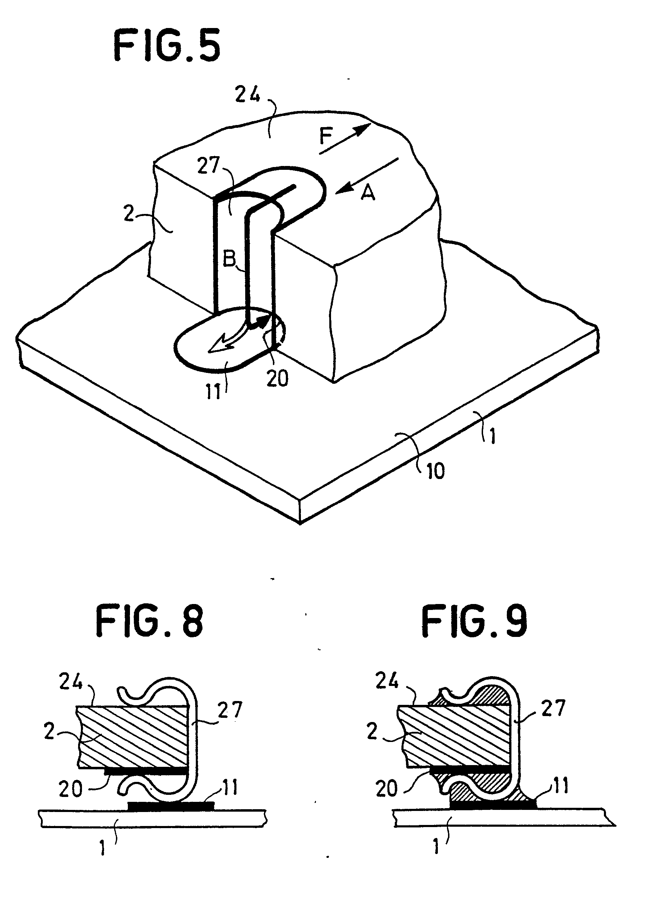

Sur la figure 5, représentant une portion du composant 2, le parcours de la brasure est représenté plus en détail. En effet, la brasure tendant à mouiller les parties métallisées, elle suit la flèche B et arrivée aux plots de connexion 11 et 20, elle les recouvre uniformément.

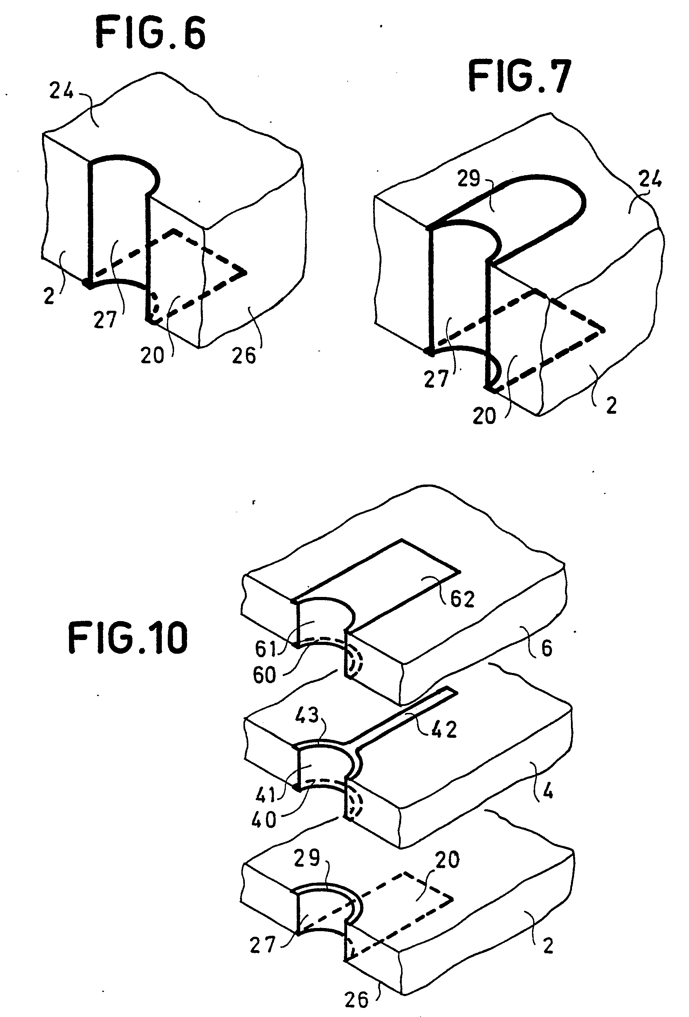

Un capteur capillaire peut être réalisé, comme cela est représenté en figure 6, sous forme d'une cannelure 27 pratiquée le long de la tranche du composant à partir du plot de connexion 20. Cette cannelure est ensuite métallisée à l'aide d'un matériau ayant des propriétés mouillantes vis-à-vis de l'alliage de brasage. L'avantage de prévoir le capteur capillaire, en forme de cannelure, est d'augmenter la surface du capteur capillaire.

Sur la figure 7, la cannelure métallisée 27 est prolongée sur la face 24, par une plage métallisée 29 de même type que la cannelure. Le captage de la brasure lors du passage sur la vague de brasure est ainsi améliorée.

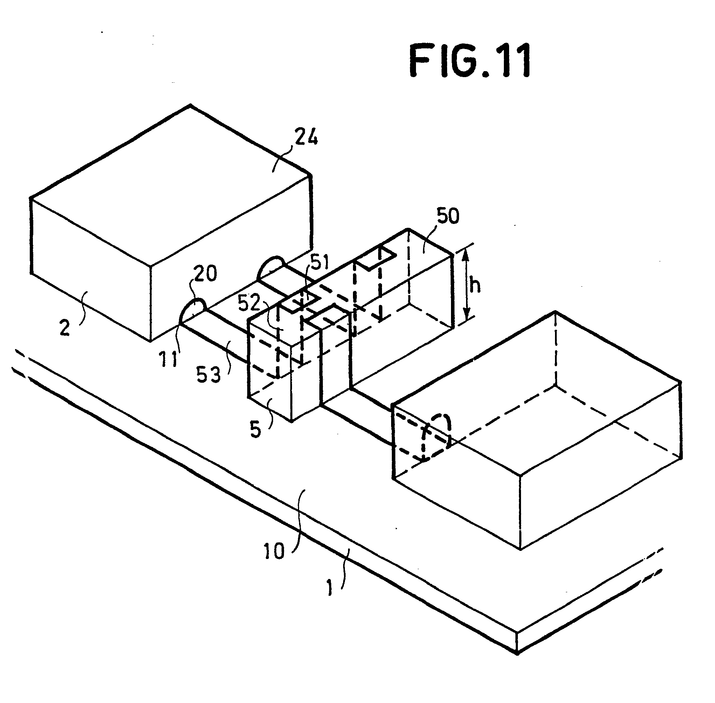

Sur la figure 8, un capteur capillaire selon l'invention a été représenté sous forme d'un cavalier 27 embroché sur la tranche du composant 2, exerçant une légère pression sur la face 24 et le plot de connexion 20. Après le passage à la vague de brasure, l'ensemble composant 2, cavalier 27, plot de connexion 20 et plot de connexion 11 se trouvent enrobés de brasure.

L'invention permet par ailleurs de résoudre les problèmes de connexion des composants à plusieurs couches. Le composant de la figure 10 comporte trois couches 2, 4 et 6.

La couche 2 porte sur sa face 26, un plot de connexion 20. La couche 4 possède une connexion 42 de circuit interne au composant. Une cannelure 27 aboutissant au plot 20 est pratiquée dans la tranche de la couche 2 et est métallisée. De même, des cannelures métallisées 41 et 61 sont pratiquées en correspondance de la cannelure 27 dans les couches 4 et 6. De plus, des embases métallisées 29, 40, 43 et 60 sont réalisées de part et d'autre des couches 2, 4, 6, autour des cannelures. Une embase métallisée 62 est également réalisée sur la face supérieure de la couche 6. Les différentes couches sont ensuite empilées, pressées et collées l'une contre l'autre. Les embases 29, 40, 43 et 63 assurent une continuité métallique de la cannelure pour améliorer l'écoulement de la brasure le long de la cannelure lors du passage à la vague de brasure.

Le capteur capillaire peut être également supporté par une autre pièce que le composant lui-même. Par exemple, sur la face 10 de la carte de circuits imprimés 1, on dispose des éléments conçus spécialement pour cet usage tels que l'élément 50. Sur l'élément 50 est déposée une bande métallisée 51, 52, 53 reliant le sommet de l'élément 50 au plot de connexion 11 de la carte. La hauteur h de l'élément 50 est telle qu'en fonction de la vague, de la hauteur des composants et de la position de l'élément 50 par rapport aux composants, la partie 51 de bande métallisée soit atteinte par la vague de brasure. Comme représenté sur la figure 11, plusieurs capteurs capillaires peuvent être prévus sur un élément 50. De même, un élément 50 peut desservir plusieurs composants.

**Revendications**

1. Dispositif pour brasage de composant en surface, ledit composant possédant sur une première face (26) au moins un plot de connexion (20) pour connexion à au moins une plage de connexion (11) d'une face (10) d'un substrat (1), le ou les plots de connexion (20) du composant et la ou les plages de connexion (11) du substrat étant situés d'un même côté du substrat (1) par rapport à ladite face (10) du substrat (1), le composant comportant une deuxième face (24) opposée à la première face (26), caractérisé en ce qu'il comporte au moins un élément métallisé (27) reliant chaque plot de connexion (20) à la deuxième face (24) et affleurant la deuxième face (24) du composant.

2. Dispositif selon la revendication 1, caractérisé en ce que l'élément métallisé (27) est un ruban métallisé.

3. Dispositif selon la revendication 2, caractérisé en ce qu'il comporte une plage métallisée (29) reliée au ruban métallisé (27) et située sur la deuxième face (24) du composant (2).

4. Dispositif selon la revendication 1, caractérisé en ce qu'il comporte au moins une cannelure métallisée disposée à la périphérie du composant et reliant un plot de connexion (20) à la deuxième face (24).

5. Dispositif selon la revendication 1, caractérisé en ce que le composant comporte plusieurs couches (2, 4, 6) empilées et pressées les unes contre les autres par leurs faces principales; des plages métallisées (29, 40, 43, 60) situées en regard les unes des autres sur chaque face principale de chaque couche; et que des éléments métallisés (27, 41, 61) relient des plages métallisées des deux faces principales de chaque couche.

6. Dispositif selon la revendication 1, caractérisé en ce que l'élément métallisé (27) est un cavalier placé sur la tranche du composant en contact avec un plot de connexion (20) du composant (2) et présentant une partie en saillie sur la deuxième face du composant (24).

7. Dispositif selon la revendication 1, caractérisé en ce qu'il comprend un élément (50) de hauteur (h) déterminée disposé sur le substrat (1) à proximité d'au moins une plage de connexion (11) du substrat ainsi qu'une bande métallisée (51, 52, 53) reliant la face supérieure de l'élément (50) à la plage de connexion (11).

8. Procédé de brasage à la vague permettant de braser les plots de connexion (20) d'un composant (2), selon l'une quelconque des revendications précédentes, à des plages de connexion (11) d'un substrat (1), ledit procédé comprenant les étapes suivantes:

– collage du composant (2) sur le substrat (1) avec les plots de connexion (20) du composant en contact avec les plages de connexion (11) du substrat;

– passage de l'ensemble substrat-composant ainsi constitué dans la vague de brasure (3) de telle façon que celle-ci touche les éléments métallisés (27);

– captage de brasure par les éléments métallisés (27);

– propagation de la brasure par capillarité le long des éléments métallisés (27) jusqu'aux plots de connexion (20) du composant et les plages de connexion (11);

– soudure des plots de connexion (20) du composant aux plages de connexion (11) du substrat.

**Claims**

1. A device for soldering a component to a surface, said component having a first surface (26) provided with at least one connection stud (20) intended to be connected to at least one connection area (11) of one surface (10) of a substrate (1), the one or more connection studs (20) of the component and the one or more connection areas (11) of the substrate being located at the same side of the substrate relative to said surface (10) of the substrate (1), and the component having a second surface (24) located opposite the first surface (26), characterized in that the device comprises at least one metallized element (27) connecting each connection stud (20) to the second surface (24) and extending up to the second surface (24) of the component.

2. A device according to claim 1, characterized in that the metallized element (27) is a metallized tape.

3. A device according to claim 2, characterized in that it comprises a metallized area (29) connected to the metallized tape (27) and located on the second surface (24) of the component.

4. A device according to claim 1, characterized in that it comprises at least one metallized notch disposed at the periphery of the component and connecting a connection stud (20) to the second surface (24).

5. A device according to claim 1, characterized in that the component comprises several layers (2, 4, 6) which are superimposed and pressed against each other via their principal surfaces, and metallized areas (29, 40, 43, 60) located on each principal surface of each layer while facing each other; and in that the metallized elements (27, 41, 61) connect with each other metallized areas of the two principal surfaces of each layer.

6. A device according to claim 1, characterized in that the metallized element (27) is a rider placed on that portion of the component which is in touch with a connection stud (20) of the component (2) and has a part projecting onto the second surface of the component (24).

7. A device according to claim 1, characterized in that it comprises an element (50) having a predetermined height (h) and being disposed on the substrate (1) near to at least one connection area (11) of the substrate, and a metallized tape (51, 52, 53) designed to connect the upper surface of the element (50) to the connection area (11).

8. A wave soldering process allowing to solder connection studs (20) of a component (2) according to anyone of the preceding claims to connection areas (11) of a substrate (1), said process comprising the following steps;

– making the component (2) adhere to the substrate (1) with the connection studs (20) of the component being in touch with the connection areas (11) of the substrate;

– passing the substrate-component assembly thus composed through the soldering wave (3) in such a way that the wave touches the metallized elements (27);

– capturing the solder by the metallized elements (27);

– propagating of the solder by virtue of capillary force along the metallized elements (27) and up to the connection studs (20) of the component and the connection areas (11); and

– welding of the connection studs (20) of the component to the connection areas (11) of the substrate.

**Patentansprüche**

1. Vorrichtung zur Oberflächenverlötung eines Bauelements, das auf einer ersten Fläche (26) mindestens einen Anschlußkontakt (20) zum Anschluß an mindstens einen Anschlußbereich (11) einer Fläche (10) eines Substrats (1) besitzt, wobei der oder die Anschlußkontakte (20) des Bauelements sowie der oder die Anschlußbereiche (11) des Substrats im Vergleich zur genannten Fläche (10) des Substrats (1) auf derselben Seite des Substrats (1) angeordnet sind und das Bauelement eine zweite Seite (24) besitzt, die der ersten Seite (26) gegenüberliegt, dadurch gekennzeichnet, daß die Vorrichtung mindestens ein metallisiertes Element (27) aufweist, das jeden Anschlußkontakt (20) mit der zweiten Fläche (24) verbindet und bis zur zweiten Fläche (24) reicht.

2. Vorrichtung nach Anspruch 1, dadurch gekennzeichnet, daß das metallisierte Elemente (27) ein metallisiertes Band ist.

3. Vorrichtung nach Anspruch 2, dadurch gekennzeichnet, daß sie einen metallisierten Bereich (29) aufweist, der mit dem metallisierten Band (27) verbunden und auf der zweiten Fläche (24) des Bauelements liegt.

4. Vorrichtung nach Anspruch 1, dadurch gekennzeichnet, daß sie mindestens eine metallisierte Hohlkehle aufweist, die an der Außenseite des Bauelements angebracht ist und den Anschlußkontakt (20) mit der zweiten Fläche (24) verbindet.

5. Vorrichtung nach Anspruch 1, dadurch gekennzeichnet, daß das Bauelement mehrere übereinandergefügte und mit ihren Hauptflächen gegeneinandergepreßte Schichten (2, 4, 6) und metallisierte Bereiche (29, 40, 43, 60) besitzt, welche auf jeder Hauptfläche jeder Schicht einander gegenüberliegen, und daß die metallisierten Elemente (27, 41, 61) die metallisierten Bereiche der beiden Hauptflächen jeder miteinander verbinden.

6. Vorrichtung nach Anspruch 1, dadurch gekennzeichnet, daß das metallisierte Element (27) ein Reiter ist, der auf dem mit dem Anschlußkontakt (20) des Bauelements (2) in Verbindung stehenden Bauelementenabschnitt angebracht ist und einen über die zweite Fläche (24) des Bauelements vorspringenden Teil besitzt.

7. Vorrichtung nach Anspruch 1, dadurch gekennzeichnet, daß sie ein Element (50) bestimmter Höhe (h), das auf dem Substrat (1) in der Nähe mindestens eines Anschlußbereichs (11) des Substrats angeordnet ist, sowie ein metallisiertes Band (51, 52, 53) besitzt, das die obere Fläche des Elements (50) mit dem Anschlußbereich (11) verbindet.

8. Wellenlötverfahren zum Anlöten der Anschlußkontakte (20) eines Bauelements (2) gemäß einem beliebigen der vorhergehenden Ansprüche, an Anschlußbereiche (11) eines Substrats (1), bestehend aus folgenden Stufen:

– Anheften des Bauelements (2) auf dem Substrat (1), so daß die Anschlußkontakte (20) des Bauelements in Verbindung mit den Anschlußbereichen (11) des Substrats stehen;

– Durchziehen der so gebildeten Einheit Substrat-Bauelement durch die Lötmittelwelle (3) derart, daß diese die metallisierten Elemente (27) berührt;

– Aufnehmen des Lötmittels durch die metallisierten Elemente (27);

– Ausbreiten des Lötmittels durch Kapillarkräfte entlang der metallischen Elemente (27) bis zu den Anschlußkontakten (20) des Bauelements und zu den Anschlußbereichen (11); und

– Anlöten der Anschlußkontakte (20) des Bauelements an die Anschlußbereiche (11) des Substrats.

# FIG.1

# FIG. 2

# FIG.3

# FIG.4

# FIG.5

# FIG. 8

# FIG. 9

11

# FIG.6

# FIG.7

# FIG.10

# FIG.11